Europäisches Patentamt

European Patent Office

Office européen des brevets

(11) Publication number: **0 182 925**
**B1**

# EUROPEAN PATENT SPECIFICATION

(45) Date of publication of patent specification: **24.05.89**

(21) Application number: **84114118.7**

(22) Date of filing: **23.11.84**

(51) Int. Cl.$^4$: **H 01 L 29/12,** H 01 L 29/78, H 01 L 49/00

(54) Insulated-gate field-effect transistor employing small band-gap material.

(43) Date of publication of application:
**04.06.86 Bulletin 86/23**

(45) Publication of the grant of the patent:
**24.05.89 Bulletin 89/21**

(84) Designated Contracting States:
**DE FR GB**

(56) References cited:
**US-A-3 308 351**

**PHYSICS LETTERS, vol. 35A, no. 6, 12th July 1971, Amsterdam, NL; C. REALE "Field effect in vacuum deposited bismuth films", pages 437-438**

**MOLECULAR CRYSTALS AND LIQUID CRYSTALS + LETTERS, vol. 86, nos. 1/4, 1982, New York, USA; D.C. WEBER et al. "Ion implantation applied to conducting polymers", page 245**

**MOLECULAR CRYSTALS AND LIQUID CRYSTALS + LETTERS, vol. 86, nos. 1/4, 1982, New York, USA; P.M. GRANT et al. "Field effect properties of polyacetylene", page 239**

(73) Proprietor: **International Business Machines Corporation**
**Old Orchard Road**
**Armonk, N.Y. 10504 (US)**

(72) Inventor: **Jaggi, Rudolf, Dr.**
**Hirschweg 3**
**CH-8135 Langnau a. Albis (CH)**

Inventor: **Mueller, Carl Alexander, Prof. Dr.**
**Haldenstrasse 54**
**CH-8908 Hedingen (CH)**

(74) Representative: **Rudack, Günter O., Dipl.-Ing.**
**IBM Corporation Säumerstrasse 4**
**CH-8803 Rüschlikon (CH)**

## Description

This invention relates to an insulated gate field-effect transistor employing a small band gap material for its current channel, which may be used, for example, as an active amplifying element in electronic circuitry.

A conventional field-effect transistor consists of two electrodes connected to a narrow channel the conductivity of which can be controlled by an electric field applied to a gate electrode which is insulated from the channel.

Known in the art are field-effect transistor structures in which the channel is made of a semiconductor material of n-type conductivity and constricted by a p-type conductivity gate region (see e.g. K. J. Dean, Integrated Electronics, Chapman and Hall, London 1967). When a potential is applied between the ends of the channel, called source and drain, respectively, an impurity current will flow passing through the constricted region and causing a potential gradient along its length. With a potential applied to the gate electrode, the p-n junction between the gate and the channel becomes reverse biased so that a depletion layer is formed near the junction. The width of this depletion layer is a function of the gate potential. Thus, with increasing gate potential, the channel becomes still more constricted, until the conductance of the channel approaches zero.

US—A—3,500,137 discloses a cryogenic device comprising a semiconductor channel permitting superconducting carrier transport in an operation mode analogous to field-effect transistors. A first gate is provided to apply a potential for controlling the depletion/enhancement of the conducting region. By application of a magnetic field via a second gate, the superconductor can be switched between superconducting and normal resistive states.

Known from EP—A—83113163.6 is a tunneling transistor with a semiconductor channel which, at low temperatures, behaves like an insulator with a low barrier through which charge carriers can tunnel under the influence of an applied drain voltage. The tunnel current is controlled by a gate voltage which modifies the barrier height between source and drain.

The field-effect transistors known in the art have various limitations among which is the temperature range in which they can operate—field-effect transistors with superconductors require helium temperatures —, and/or their relatively low cutoff frequency.

It is, therefore, an object of the present invention to propose an insulated-gate field-effect transistor employing normal-conducting materials operating at room temperature as well as at low temperatures down to liquid helium temperature and yet having a relatively high cutoff frequency in the neighbourhood of 16 GHz.

These goals can be achieved in accordance with the present invention with an insulated-gate field-effect transistor employing a semimetallic channel material such as bismuth or a bismuth alloy, or a small band-gap semi-conductor mateerial. The proposal to use these materials is based on the cognition that they have a very high mobility of their charge carriers, also at low temperatures, and that they show a sufficiently great field dependence. This is in contrast to the classical semi-conductors, viz. silicon and germanium, in which the charge carriers, even from shallow donors, are frozen out at low temperatures, in other words, their mobility becomes virtually zero.

The field dependency of the resistivity of bismuth is known from Y. F. Ogrin, V. N. Lutskii and M. I. Elinson, Field Effect in Bismuth, Sov. Phys.—Solid State 9 (1968) 2547; C. Reale, Field Effet in Vacuum-Deposited Bismuth Films, Phys. Lett. 35A (1971) 437; and D. A. Glocker and M. J. Skove, Field Effect and Magnetoresistance in Small Bismuth Wires, Phys, Rev. B 15 (1977) 608. Of particular importance in connection with the present invention is the observation of the field-effect in this bismuth films.

In addition to pure bismuth, the invention contemplates the use of bismuth alloys for the current channel, with a preference placed on bismuth-antimony alloys. Alloying antimony to bismuth yields a continuous transition from semimetallic bismuth to a semiconductor. The overlap of valence and conduction bands, typical for semimetals, disappears at 5% antimony in the alloy. The activation energy has a maximum value of 14 meV at 12% antimony.

Accordingly, the present invention relates to an insulated-gate field-effect transistor in accordance with claim 1.

Details of an embodiment of the invention will hereafter be described by way of example with reference to the attached drawings in which:

Fig. 1 is a schematic representation of the field-effect transistor in accordance with the invention;

Fig. 2 is a diagram showing the ratio of the electrical conductivity of bismuth films to the conductivity of bulk material as a function of the electric field $E_x$ for various film thicknesses d.

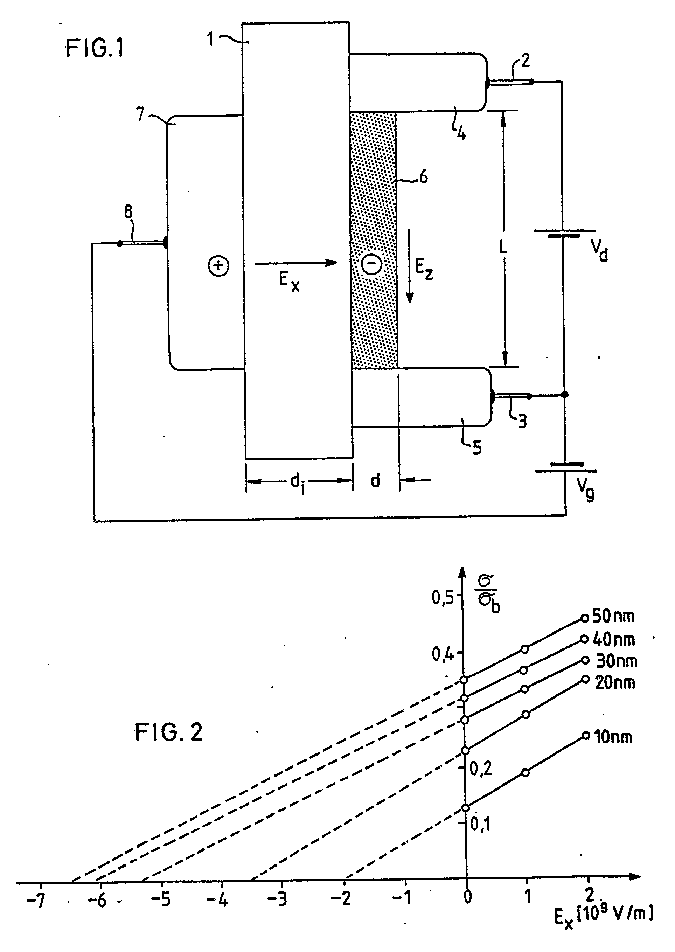

Referring to Fig. 1, there is shown a field-effect transistor structure comprising an insulator 1 carrying on one side a drain region 4 and a source region 5, respectively fitted with electrodes 2 and 3. Extending on insulator 1 between drain region 4 and source region 5 is a thin film 6 consisting of a semimetal, viz. bismuth. On the other side of insulator 1 opposite bismuth film 6 is a gate region 7 carrying an electrode 8.

Drain region 4 and source region 5 form ohmic contacts with bismuth film 6. In view of the fact that in a semimetal conduction and valence bands overlap, the current flowing in bismuth film 6 is not necessarily unipolar since both electrons and holes may contribute. Accordingly, the configuration in accordance with the invention is an alternative to the known unipolar field-effect transistors. In contrast to the known MESFET, no Schottky barrier is used for altering the geometry of the channel; in contrast to the known MOSFET, no p-n junctions at source and drain and no induced channel in an inversion layer under the gate are formed. Evidently, these differences account for advantages in the fabrication and operation. In particular, parasitic resistances in the source and drain regions can be kept low.

The gate region 7 may in principle consist of a metal or a semiconductor. Of course, for applications of the field-effect transistor in accordance with this invention at low temperatures, the semiconductor material will not be suitable.

In the following, the characteristics of a field-effect transistor constructed in accordance with this description will be reviewed. Fig. 2 shows the ratio of the electrical conductivities of bismuth films and bulk material ($\sigma/\sigma_b$) as a function of the electric field $E_x$ for various film thicknesses d, using experimental data of C. Reale, published in his Phys. Lett. article mentioned above. In agreement with Fig. 2, the conductivity $\sigma$ of bismuth films of 10 to 50 nm thickness can well be approximated by

$$\sigma = \sigma_o(d)(1 + \frac{E_x}{E_o(d)}) \qquad (1)$$

where $\sigma_o(d)$ is the conductivity in the absence of an electric field, d is the thickness of the bismuth film, $E_x$ is the transverse electric field, and $E_o(d)$ is the critical electric field.

Using Fig. 2, the value $\sigma_o$ for a d=10 nm thick bismuth film is $\sigma_o = 1 \times 10^5$ A/Vm and the critical electric field is $E_o = -2 \cdot 10^9$ V/m.

In the configuration shown in Fig. 1, the gate field is $E_x = Vg/d_i$ and the drain field $E_z = -V_d/L \ll |E_x|$. The drain current per width w results to

$$\frac{I_d}{w} = \sigma_o(1 - \frac{V_g}{E_o d_i} \frac{d}{L})V_d, \qquad (2)$$

and the transconductance

$$\frac{g_m}{w} = \frac{1}{w} \frac{\partial I_d}{\partial V_g} V_d = -\sigma_o \frac{d}{E_o d_i L} V_d. \qquad (3)$$

For a bismuth film with the material parameters given above and with a gate length L=1 μm, for an insulator thickness of $d_i$=50 nm, a drain voltage of $V_d$=1 V, the transconductance per width becomes

$$\frac{g_m}{2} = 10 \frac{A}{Vm}. \qquad (4)$$

Introducing the gate capacitance per width

$$\frac{C_i}{w} = \varepsilon_o \varepsilon_i \frac{L}{d_i}, \qquad (5)$$

the cutoff frequency of the field-effect transistor of Fig. 1 becomes

$$f_{co} = \frac{g_m}{2\pi C_i} = \frac{\sigma_o d V_d}{2\pi \varepsilon_o \varepsilon_i |E_o| L^2}[s^{-1}] \qquad (6)$$

If the insulator is chosen as $Al_2O_3$, $\varepsilon_i$=9. The cutoff frequency thus is

$$f_{co} = 10^9 s^{-1} \text{ at room temperature.} \qquad (7)$$

By inserting

$$\sigma_o = Ne\mu_{eff} \qquad (8)$$

with M being the carrier concentration, and e the charge of an electron, and

$$\varepsilon_o \varepsilon_i E_o \sim Ned \qquad (9)$$

into equation (6), we get the standard expression for the cutoff frequency of MOSFET's for the case of drain voltages below saturation:

$$f_{co} = \frac{\mu_{eff} V_d}{2\pi L^2}(V_d \ll V_{ds}). \qquad (10)$$

Using again equations (8) and (9), the effective mobility follows as:

$$\mu_{eff} = \frac{\sigma_o d}{\varepsilon_o \varepsilon_i E_o}. \qquad (11)$$

For the bismuth film under consideration, for room temperature, one gets

$$\mu_{eff} = 6.3 \cdot 10^{-3} \frac{m^2}{Vs}$$

and the carrier concentration

$$N = \frac{\sigma_o}{\sigma \mu_{eff}} = 10^{26} m^{-3}. \qquad (12)$$

The parameters chosen for the foregoing calculation on the basis of the work by C. Reale yield a good transistor performance ah room temperature. It is known to those skilled in the art that with falling temperature the carrier mobility in bismuth increases while the carrier concentration decreases. In accordance with A. L. Jain, Temperature Dependence of the Electrical Properties of Bismuth-Antimony Alloys, Phys. Rev. 114 (1959) 1518, the following table gives orders of magnitude of this dependence for pure bulk bismuth:

| T [K] | $\mu_{eff}$ [m²/Vs] | N [m⁻³] |
|---|---|---|
| 300 | $>10^{-2}$ | $10^{26}$ |
| 77 | 10 | $10^{24}$ |
| 4,2 | $10^3$ | $10^{23}$ |

Straightforward application of equation (10) leads to surprisingly high cutoff frequencies at low temperatures, viz. $f_{co} \sim 10^{12}$ Hz at 77 K and even $\sim 10^{14}$ Hz at 4.2 K. However, the use of bismuth alloys and thin films rather than pure bulk bismuth certainly requires the modification of Jain's data, yet there is a remarkable tendency toward high cutoff frequencies at low temperatures. Also, the critical field $E_o$ will be considerably reduced.

At low drain voltages, the drift velocity of the carriers is

$$V_{drift} = \mu_{eff} \frac{V_d}{L}. \qquad (13)$$

If we rewrite equation (10) accordingly, we get

$$f_{co} = \frac{V_{drift}}{2\pi L} \qquad (14)$$

At high drain voltages, a non-linear behavior of $V_{drift}$ as a function of $V_d$ leading to saturation might be expected. Apparently, saturation drift velocities $v_s$ in semimetals like bismuth and bismuth alloys have so far not been reported in the literature. However, it does not seem to be too far-fetched if one speculates that the drift velocity in semimetals is in the same order of magnitude as in semi-conductors, viz. $v_s > 10^5$ m/s. Accordingly, the cutoff frequency in the saturation regime for the field-effect transistor with the before-mentioned specification would be

$$f_{co} > 16 \cdot 10^9 \text{ Hz.}$$

Insulated-gate field-effect transistors employing semimetals appear to become competitive with other devices at 77 K, and certainly below this temperature, because of their advantageous carrier mobility versus temperature characteristics. Besides bismuth and its alloys, other semimetals may be employed in the field-effect transistor of the present invention. The high carrier mobilities in the basal planes of quasi-two-dimensional structures of graphite and graphite intercalation compounds as described by S. A. Solin, the Nature and Structural Properties of Graphite Intercalation Compounds, Adv. Chem. Phys. 49 (1982) 455 may be used, whereby the controlling electric field $E_x$ (Fig. 1) should preferably be perpendicular to the basal plane.

Also, quasi-one-dimensional structures like doped polymeres, such as polyacetylene and others, show high initial drift velocities, as was reported by B. Movaghar and N. Cade, Spontaneous Localization of Excitations in Polydimethylenes, J. Phys. C15 (1982) L807. Another example for an organic substance with high carrier mobility which may be employed in the field-effect transistor of the present invention is the organic metal $(TMTSF)_2PF_6$ as described by P. M. Chaikin, Mu-Yong Choi, P. Haen, E. M. Engler and R. L.

Green, Magnetotransport and Non-Linear Effects in $(TMTSF)_2PF_6$ Semiconducting Organic Compounds, Mol. Cryst. Liq. Cryst., Vol. 79, Nr. 1—4. Jan. 1982, Proc. of the Int. Conf. on Low-Dimens. Conduct, Part. B. Boulder Colo, Aug. 9—14, 1981, p. 79—94.

**Claims**

1. Insulated-gate field-effect transistor having drain, source and gate electrodes (4, 5, 7) and an insulator (1) separating said gate electrode (7) from said drain and source electrodes (4, 5), characterized in that a film (6) of a material having a band gap between +0.3 eV and −0.3 eV at the Fermi level and having a thickness of between 10 and 50 nm extends on said insulator (1) on its side opposite from said gate electrode (7) and between said drain electrode (4) and said source electrode (5), said insulator (1) having a thickness $d_l$ on the order of 50 nm, that said drain and source electrodes (4, 5) are in ohmic contact with said film (6), such that with a first potential ($V_g$) applied between said gate electrode (7) and said source electrode (4) an electric field exists across said insulator (1), said field controlling the flow of current between said drain and source electrodes (4, 5) as a second potential ($V_d$) is applied therebetween.

2. Field-effect transistor in accordance with claim 1, characterized in that said film (6) consists of a semiconductor material having a band gap between +0,3 and 0 eV.

3. Field-effect transistor in accordance with claim 1, characterized in that said film (6) consists of a semimetal material having a band gap of <0eV up to −0,3 eV.

4. Field-effect transistor in accordance with claim 3, characterized in that said film (4) consists of bismuth.

5. Field-effect transistor in acocrdance with claim 3, characterized in that said film (6) consists of a bismuth alloy.

6. Field-effect transistor in accordance with claim 3, characterized in that said film (6) consists of graphite.

7. Field-effect transistor in accordance with claim 3, characterized in that said film (6) consists of a graphite intercalation compound.

8. Field-effect transistor in accordance with claim 3, characterized in that said film (6) consists of a doped polymer.

9. Field-effect transistor in accordance with claim 3, characterized in that said film (6) consists of an organic metal.

10. Field-effect transistor in accordance with claim 5, characterized in that said film (6) consists of a bismuth-antimony alloy.

**Patentansprüche**

1. Feldeffekttransistor mit isoliertem Gate, mit Drain-, Source- und Gateelektroden (4, 5, 7) und einem Isolator (1) der die genannte Gateelektrode (7) von den genannten Drain- und Sourceelektroden (4, 5) trennt, dadurch gekennzeichnet, daß ein Film aus einem Material mit einem Bandabstand zwischen +0,3 eV und −0,3 eV auf dem Fermi-Niveau und mit einer Dicke d zwischen 10 und 50 nm sich auf dem isolator (1) auf dessen der Gateelektrode (7) gegenüberliegenden Seite und zwischen den genannten Drain- und Sourceelektroden (4, 5) erstreckt, daß der isolator (1) eine Dicke $d_i$ von der Größenordnung 50 nm aufweist, und daß die genannten Drain- und Soureelektroden (4, 5) mit dem Film (6) ohmschen Kontakt haben, so daß beim Anlegen eines ersten Potentials ($V_g$) zwischen den genannten Gate- und Sourceelektroden (7, 5) ein elektrisches Feld über dem isolator (1) existiert, welches Feld den Stromfluß zwischen den genannten Drain- und Sourceelektroden (4, 5) steuert, wenn ein zweites Potential ($V_d$) zwischen diesen angelegt ist.

2. Feldeffekttransistor gemäß Anspruch 1, dadurch gekennzeichnet, daß der genannte Film (6) aus einem Halbleitermaterial mit einem Bandabstand zwischen +0,3 und 0 eV besteht.

3. Feldeffekttransistor gemäß Anspruch 1, dadurch gekennzeichnet, daß der genannte Film (6) aus einem Halbmetallmaterial mit einem Bandabstand von <0 eV bis −0,3 eV besteht.

4. Feldeffekttransistor gemäß Anspruch 3, dadurch gekennzeichnet, daß der genannte Film (6) aus Wismut besteht.

5. Feldeffekttransistor gemäß Anspruch 3, dadurch gekennzeichnet, daß der genannte Film (6) aus einer Wismutlegierung besteht.

6. Feldeffekttransistor gemäß Anspruch 3, dadurch gekennzeichnet, daß der genannte Film (6) aus Graphit besteht.

7. Feldeffekttransistor gemäß Anspruch 3, dadurch gekennzeichnet, daß der genannte Film (6) aus einer Graphit-intercalation-Verbindung besteht.

8. Feldeffekttransistor gemäß Anspruch 3, dadurch gekennzecihnet, daß der genannte Film (6) aus einem dotierten Polymer besteht.

9. Feldeffekttransistor gemäß Anspruch 3, dadurch gekennzeichnet, daß der genannte Film (6) aus einem organischen Metall besteht.

10. Feldeffekttransistor gemäß Anspruch 5, dadurch gekennzeichnet, daß der genannte Film (6) aus einer Wismut-Antimon-Legierung besteht.

**Revendications**

1. Transistor à effet de champ à grille isolée possédant des électrodes de drain, de source et de grille (4, 5, 7) et un isolant (1) séparant l'électrode de grille (7) des électrodes de drain et de source (4, 5), caractérisé en ce qu'un film (6) d'une substance ayant un intervalle de bande compris entre +0,3 eV et −0,3 eV au niveau de Fermi et possédant une épaisseur d'comprise entre 10 et 50 nm s'étend sur l'isolant (1) sur le côté opposé à l'électrode de grille (7) et entre l'électrode de drain (4) et l'électrode de source (5), l'isolant (1) ayant une épaisseur $d_i$ de l'ordre de 50 mm, en ce que les électrodes de drain et de source (4, 5) sont en contact obmique avec le film (6) de sorte qu'un premier potentiel ($V_g$) étant appliqué entre l'électrode de grille (7) et l'électrode de source (4) il existe un champ électrique à travers l'isolant (1), ce champ contrôlant le courant entre les électrodes de drain et de source (4, 5) alors qu'un second potentiel ($V_d$) est appliqué entre elles.

2. Transistor à effet de champ selon la revendication 1, caractérisé en ce que le film (6) est constitué d'une substance semiconductrice possédant un intervalle de bande compris entre +0,3 et 0 eV.

3. Transistor à effet de champ selon la revendication 1, caractérisé en ce que le film (6) est constitué d'une substance semi-métallique possédant un intervalle de bande négatif jusqu'à −0,3 eV.

4. Transistor à effet de champ selon la revendication 3, caractérisé en ce que le film (6) est constitué de bismuth.

5. Transistor à effet de champ selon la revendication 3, caractérisé en ce que le film (6) est constitué par un alliage du bismuth.

6. Transistor à effet de champ selon la revendication 3, caractérisé en ce que le film (6) est constitué par du graphite.

7. Transistor à effet de champ selon la revendication 3, caractérisé en ce que le film (6) est constitué par un composé à graphite intercalaire.

8. Transistor à effet de champ selon la revendication 3, caractérisé en ce que le film (6) est constitué d'un polymère dopé.

9. Transistor à effet de champ selon la revendication 3, caractérisé en ce que le film (6) est constitué d'un métal organique.

10. Transistor à effet de champ selon la revendication 5, caractérisé en ce que le film (6) est constitué d'un alliage bismuth-antimoine.

FIG.1

FIG. 2